(19) Europäisches Patentamt
European Patent Office
Office européen des brevets

(11) Publication number: **0 460 763 A2**

# EUROPEAN PATENT APPLICATION

(21) Application number: 91201371.1

(22) Date of filing: 04.06.91

(51) Int. Cl.⁵: **H01L 39/22**, H01L 39/24

(30) Priority: 08.06.90 NL 9001301

(43) Date of publication of application:
**11.12.91 Bulletin 91/50**

(84) Designated Contracting States:
**DE FR GB**

(71) Applicant: **N.V. Philips' Gloeilampenfabrieken**
**Groenewoudseweg 1**
**NL-5621 BA Eindhoven(NL)**

(72) Inventor: **Haisma, Jan**
**c/o INT. OCTROOIBUREAU B.V., Prof.**
**Holstlaan 6**
**NL-5656 AA Eindhoven(NL)**
Inventor: **van der Kruis, Franciscus Josephus**
**Henri Maria**
**c/o INT. OCTROOIBUREAU B.V., Prof.**
**Holstlaan 6**
**NL-5656 AA Eindhoven(NL)**
Inventor: **Bongers, Piet Frans**
**c/o INT. OCTROOIBUREAU B.V., Prof.**
**Holstlaan 6**
**NL-5656 AA Eindhoven(NL)**
Inventor: **Passing, Helga**
**c/o INT. OCTROOIBUREAU B.V., Prof.**
**Holstlaan 6**
**NL-5656 AA Eindhoven(NL)**

(74) Representative: **Pennings, Johannes et al**
**Internationaal Octrooibureau B.V. Prof.**
**Holstlaan 6**
**NL-5656 AA Eindhoven(NL)**

(54) **Method of manufacturing a superconductor device.**

(57) A method of manufacturing an electronic device consisting of oxidic superconducting material and semiconducting material, a sharp interface between a first element of oxidic superconducting material and a second element of semiconducting material being obtained by providing the first and the second element with smooth, flat and actively bonding surfaces which are brought into contact with each other and are bonded together by mutually attracting forces.

FIG.1d

EP 0 460 763 A2

The invention relates to a method of manufacturing an electronic device consisting of oxidic superconducting material and semiconducting material, with at least an interface between a first element of oxidic superconducting material and a second element of semiconducting material.

The invention provides superconductor devices comprising one or more superconducting transistors, for example current injection transistors and/or field effect transistors. The invention can also be used for the manufacture of resistanceless conductor patterns in semiconductor devices. Oxidic superconducting materials, having a transition temperature $T_c$ (below which the material exhibits superconducting behaviour) of 90 K and higher, are suitable for devices having an operating temperature of, for example, 77 K, which is the temperature of liquid nitrogen.

In European Patent Application EP-A-327493, a description is given of a method in which a layer of oxidic superconducting material is epitaxially grown on a substrate carrying a layer of semiconducting material, i. e. silicon. Although it is stated that a direct contact between the semiconducting and the superconducting layer is desirable, an intermediate layer serving as a buffer between the layers is provided. This appeared to be necessary because the manufacture of oxidic superconducting materials having a sufficiently high transition temperature $T_c$ requires such high temperatures (up to 900°C) that diffusion of silicon in the superconducting material occurs, so that both the semiconducting and the superconducting material obtain properties which are unsuitable for the intended purpose. It is particularly difficult to generate a supercurtent in the semiconducting material by means of the proximity effect, when the boundary layer of the superconducting material is no longer superconducting itself.

It is an object of the invention to provide, inter alia, a method of manufacturing an electronic device in which an oxidic superconducting material and a semiconducting material are in direct contact with each other, an atomic, sharp interface being obtained without the necessity of crystal-lattice adaptation of both materials, as is the case with a hetero-epitaxial transition. It is desired for the oxidic superconducting material to maintain the proper composition to as close to the interface as possible, for which reason there must be no reaction with the semiconducting material in the form of the diffusion of, for example, silicon to the superconducting material or the escape of oxygen from the superconducting material. Therefore, it is an object of the invention to provide a method which can be carried out at a low temperature, preferably at room temperature.

According to the invention, this object is achieved by a method as described in the opening paragraph, in which the interface is obtained by providing the first and the second element with smooth, flat and actively bonding surfaces which are brought into contact with each other and are bonded together by mutually attracting forces. In literature, various designations are used for this spontaneous bonding technique: Van der Waals bonding, direct bonding, bonding by optical contact, and wringing in contact.

A further object of the invention is to provide a method of manufacturing a body of an oxidic superconducting material having a smooth, flat and actively bonding surface, which is suitable to be bonded to a second body by mutually attracting forces.

In accordance with a suitable embodiment of the method according to the invention, a layer of oxidic superconducting material having a smooth, flat and actively bonding surface is manufactured by hetero-epitaxially growing oxidic superconducting material.

In the particular case that the oxidic superconducting material consists of $YBa_2Cu_3O_{7-\delta}$, where $\delta$ has a value of 0.1 to 0.5, suitable results are obtained by hetero-epitaxially growing the oxidic superconducting material on the (023) plane of a substrate of strontium titanate $SrTiO_3$.

According to an alternative method of the invention, a layer of oxidic superconducting material having a smooth, flat and actively bonding surface is manufactured from polycrystalline material by polishing.

Thin layers of oxidic superconducting material can be obtained with various methods which are known per se. In general, a treatment at a high temperature is required to obtain the desired composition, in particular as regards the oxygen balance and the valence of the metal atoms, notably copper atoms. Thin layers of the oxidic superconducting material $YBa_2Cu_3O_{7-\delta}$ are manufactured according to M. Gurvitch et. al., see Applied Physics Letters 51 (13), pages 1027-1029 (1987), by means of dc magnetron sputter deposition using metallic target plates in an oxidizing atmosphere, followed by annealing at a high temperature, for example 800° to 900°C. Other much used methods include evaporation, sputtering, molecular beam epitaxy, laser ablation and chemical deposition from the vapour phase. In Applied Physics Letters 52 (21), pages 1828-1830 (1988), C.E. Rice et. al. describe a method of manufacturing thin layers of Ca-Sr-Bi-Cu oxides by means of vacuum evaporation of $CaF_2$, $SrF_2$, Bi and Cu, followed by oxidation steps at 725° and 850°C. Many of the known methods, such as the method mentioned above and also ceramic methods, lead to the formation of a polycrystalline material which does not have a great mechanical strength. It is difficult to polish such materials in a manner such that they are smooth and flat. In a suitable embodiment of the method according to the invention, the oxidic superconducting material is polished by means of polishing on pitch with the exclusion of water. The exclusion of water is necessary because many oxidic superconducting materials are hygroscopic and/or are adversely affected by water.

A method of epitaxially growing oxidic superconducting materials is known *per se*, see for example an article by P. Chaudhari et. al., in Physical Review Letters 58 (25), pages 2684 to 2686 (1987).

A method of manufacturing semiconducting layers having a smooth, flat and actively bonding surface, and of manufacturing bonds by means of mutually attracting forces is described in European Patent Application EP-A-209173.

The manufacture of superconducting transistor elements (from non-oxidic superconducting material) is described in European Patent Applications EP-A- 147482 and EP-A-257474.

The invention will be explained in greater detail by means of exemplary embodiments and with reference to the accompanying drawing, in which

Fig. 1a-d diagrammatically shows a number of steps of a method according to the invention, and

Fig. 2a-e diagrammatically shows a number of steps of an alternative method according to the invention.

Exemplary embodiment 1.

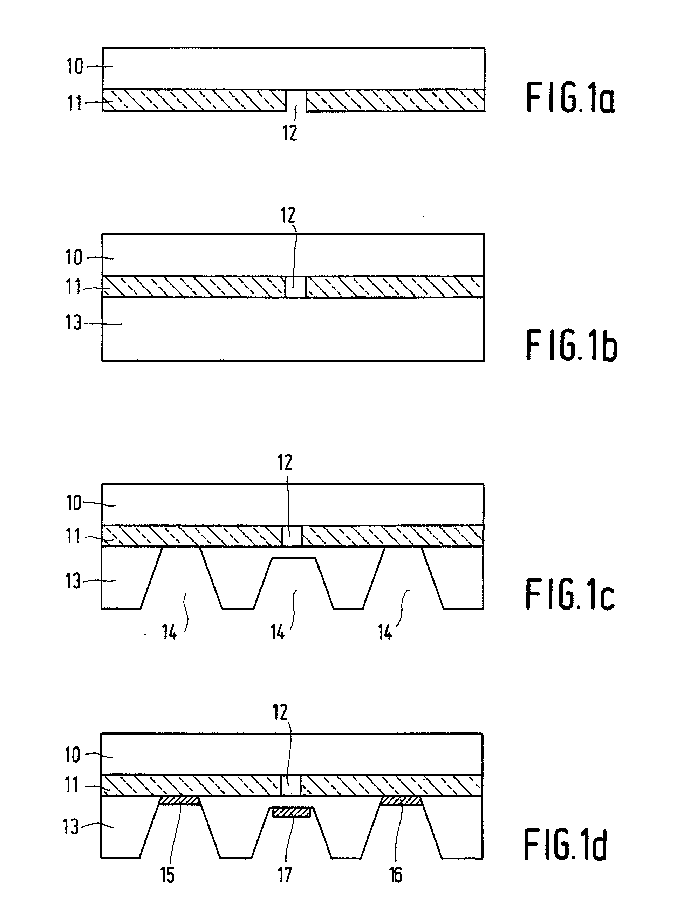

Fig. 1a shows a substrate 10 which consists of $SrTiO_3$ on which a layer 11 is provided which consists of orthorhombic $YBa_2Cu_3O_{7-\delta}$, where $\delta$ has a value of 0.1 to 0.3. The superconducting material was manufactured by hetero-epitaxial growth, the lattice constants of the (001) plane of the superconducting material were found to match those of the (023) plane of the substrate. The method concerning hetero-epitaxial growth is described in the above-mentioned article by P. Chaudhari et. al. in Physical Review Letters 58 (25), pages 2684 to 2686 (1987). An alternative method consists in sputtering on a strontium titanate substrate at an argon pressure of 0.4 Pa, followed by annealing in oxygen at 850° C for 30 minutes.

If desired, the surface of the superconducting material can be polished, for example for 3 minutes, according to the method described in the following exemplary embodiment by polishing on pitch. The smooth and flat surface of the hetero-epitaxially grown material can also be made actively bonding by soft polishing in ethylene glycol. Such methods are described by J. Haisma et. al. in Japanese Journal of Applied Physics 28 (8), pages 1426 to 1443 (1989), in particular on page 1430.

Substitutions in the superconducting material can be carried out in known manner without the effectiveness of the method according to the invention being adversely affected. For example, Y can be completely or partly substituted by rare earth metal ions, Ba can be substituted by Sr or Ca, and O can be partly substituted by F. The invention can also be applied using other oxidic superconducting materials, such as Ca-Sr-Bi-Cu oxides, where Bi can be partly substituted by Pb, $(La, Sr)_2CuO_4$ and cuprates which, in addition to Tl, also comprise Ca and/or Ba. The lattice constants and the cut of the crystal of the substrate material must be adapted to the lattice constants of the superconducting material in question.

A slot 12 having a width of approximately 0.2 $\mu$m and a depth equal to the thickness of the layer, for example 2 $\mu$m, is formed in the superconducting layer 11. Said slot was manufactured using a focused ion beam. Alternatively, an electron-lithographic method can be used for this purpose.

By means of mutually attracting forces, the superconducting layer 11 is bonded to a body 13 of silicon having a surface which is preferably free of a natural oxide layer, see Fig. 1b. A suitable method of preparing a body of semiconducting material is described in European Patent Application EP-A-209173. The surface of the semiconductor body may be provided with doped or undoped structures in known manner.

Apertures 14 are etched in the semiconductor material 13, such that at the location of the slot 12 a thin layer of silicon having a thickness of 0.1 $\mu$m remains, which layer will provide electrical transport in the field effect transistor to be manufactured. The etching operation is carried out according to a method which is known *per se* using KOH, etching preferably being carried out along the (111) planes, see Fig. 1c. Below the slot, the etching operation is stopped sooner than elsewhere.

Electrodes are provided in the apertures 14, see Fig. 1d, the electrodes 15 and 16 contacting a source region and a drain region, respectively, of the field effect transistor formed. The electrode 17 is the gate by means of which the current can be sent through the underlying, thin silicon layer. The contacts can be manufactured by, for example, vacuum evaporating or sputtering a layer of silver having a thickness of 0.1 $\mu$m and a layer of gold having a thickness of 0.3 $\mu$m, followed by annealing in oxygen for 1 hour at 450° C.

Exemplary embodiment 2.

$Y_2O_3$, BaO and CuO powders were thoroughly mixed in a stoichiometric ratio in isopropanol and subsequently annealed at 850°C for 50 hours. The powder was then ground in an agate ball mill for 2 hours. The average particle size was 2.6 $\mu$m. The powder was sieved to remove agglomerates larger than 100 $\mu$m. After compression moulding at a low pressure the material was sintered in oxygen in the following steps:

- heating at a rate of 250 K/h to 950°C,
- two hours at 950°C,
- cooling at a rate of 100 K/h to 400°C,
- 6 hours at 400°C,
- cooling at a rate of 100 K/h to room temperature.

The material thus obtained has a density of 90 to 92% of the theoretical value, which is sufficient and at least necessary to obtain satisfactory bonds by means of mutually attracting forces. The material is single-phase having an orthorhombic structure with lattice constants a = 0.382 nm, b = 0.388 nm and c = 1.169 nm. The grain structure of the material consists of plates having average dimensions of 2 x 10 x 10 $\mu$m. The quantity of oxygen is 6.9 atoms per formula unit ($\delta$ = 0.1). The transition temperature $T_c$ is 90 K.

The body manufactured was attached to a flat aluminium plate by means of cement, after which the surface of the superconductor material was ground with silicon carbide grains in ethylene glycol, so that a flat and matt surface was obtained. Subsequently, the surface was polished using aluminium oxide powder, having an average particle size of 0.3 $\mu$m, in ethylene glycol. The mixture of ethylene glycol and aluminium oxide had a viscosity of 19.9 mPa.s at 20°C. The substrate on which the polishing operation was carried out consisted of pitch, the rate of rotation of the polishing disc was 100 revolutions per minute and the polishing pressure was between 100 and 500 g/cm². The surface obtained after twenty minutes of polishing has a flatness with deviations smaller than 1 $\mu$m and exhibits a roughness of less than 0.01 $\mu$m.

It is noted, that by using a polishing cloth instead of pitch, a surface was obtained of which the smoothness, flatness and bonding activity was insufficient to bring about bonding by means of mutually attracting forces.

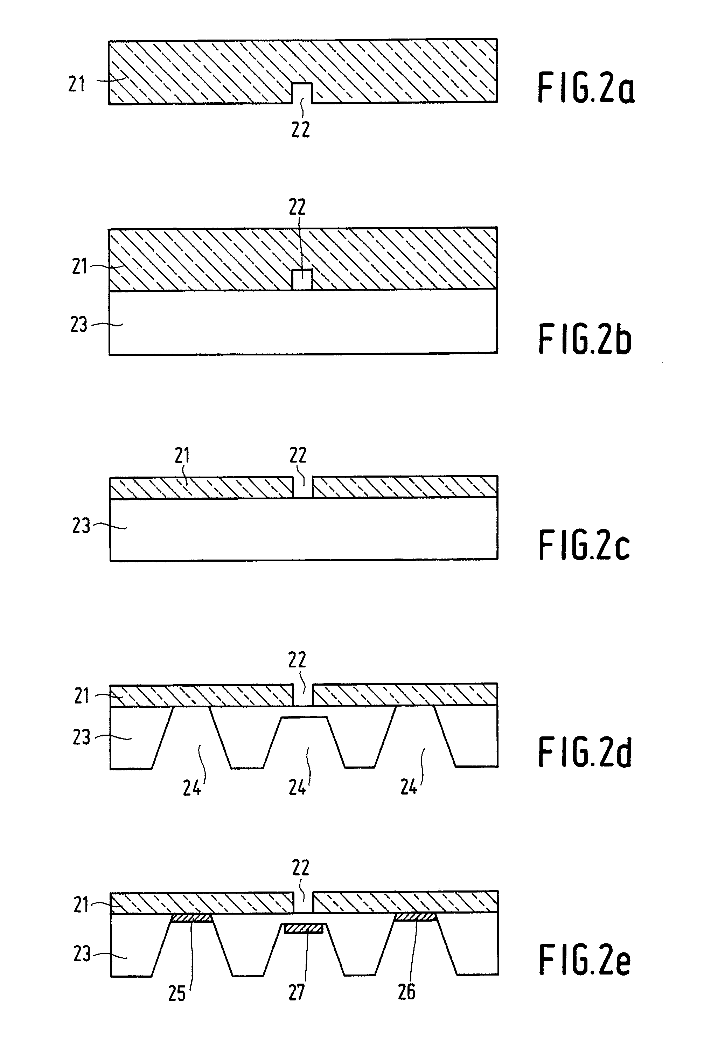

Fig. 2a shows a body 21 of the superconducting material produced, a slot 22 having a width of approximately 0.2 $\mu$m and a depth of approximately 2 $\mu$m being formed in said body.

An optically smooth disc of monocrystalline silicon was polished and provided with a very thin, unavoidable layer of silicon oxide by means of the following treatment:

- rinsing for 20 minutes at 110°C in a 1 : 1 : 1 mixture of sulphuric acid, hydrogen peroxide and water,
- immersing in a 1% solution of hydrogen fluoride in water for 20 seconds,
- rinsing for 20 minutes in 100% nitric acid,
- immersing in a 1% solution of hydrogen fluoride in water for 20 seconds,
- rinsing for 20 minutes at 90°C in a 1 : 1 : 3 mixture of ammonia, hydrogen peroxide and water,
- polishing for 20 seconds with a suspension of silicon oxide powder having an average particle size of 75 to 100 nm in a solution of sodium hydroxide in water,
- rinsing for 20 minutes in a 65% solution of nitric acid in water.

Between each of the said steps a rinsing operation in clean water was carried out for 20 minutes. An alternative method of preparing the silicon surface is described by A. Ishizaka et. al. in Journal of the Electrochemical Society 133 (4), pages 666 to 671 (1986). The chemical oxide layer has a thickness of 0.5 to 0.8 nm. A natural oxide layer on silicon has a thickness of 1.5 to 4.0 nm, which hampers the generation of a supercurrent by means of the proximity effect.

Subsequently, the body 21 of superconducting material and the silicon disc 23 were placed against each other and bonded together by mutually attracting forces, see Fig. 2b. The polycrystalline superconducting material is made thin by grinding to a thickness which is less than the depth of the slot 22, see Fig. 2c.

The following steps correspond to those of the preceding exemplary embodiment. Apertures 24 are etched in the semiconductor material 23, such that a thin layer of silicon having a thickness of 0.1 $\mu$m remains at the location of the slot 22, which thin layer forms an electrical transport region, see Fig. 2d. Electrodes 25 and 26 are provided in the apertures, which electrodes contact a source region and a drain region, respectively. The electrode 27 is the gate with which the current can be sent through the transport layer.

## Claims

1. A method of manufacturing an electronic device consisting of oxidic superconducting material and semiconducting material, with at least an interface between a first element of oxidic superconducting material and a second element of semiconducting material, characterized in that the interface is obtained by providing the first and the second element with smooth, flat and actively bonding surfaces which are brought into contact with each other and are bonded together by mutually attracting forces.

2. A method as claimed in Claim 1, characterized in that a layer of oxidic superconducting material having a smooth, flat and actively bonding surface is manufactured by hetero-epitaxially growing the oxidic superconducting material.

3. A method as claimed in Claim 2, in which the oxidic superconducting material consists of $YBa_2Cu_3O_{7-\delta}$, where $\delta$ has a value of 0.1 to 0.5, characterized in that the oxidic superconducting material is hetero-epitaxially grown on the (023) plane of a substrate of strontium titanate $SrTiO_3$.

4. A method as claimed in Claim 1, characterized in that a layer of oxidic superconducting material having a smooth, flat and actively bonding surface is manufactured from polycrystalline material by polishing.

5. A method as claimed in Claim 4, characterized in that the oxidic superconducting material is polished by polishing on pitch with the exclusion of water.

FIG.1a

FIG.1b

FIG.1c

FIG.1d

FIG.2a

FIG.2b

FIG.2c

FIG.2d

FIG.2e